# Europäisches Patentamt
# European Patent Office
# Office européen des brevets

(19)

(11) Veröffentlichungsnummer: **0 097 227**
**B1**

(12) # EUROPÄISCHE PATENTSCHRIFT

(45) Veröffentlichungstag der Patentschrift:
**27.08.86**

(21) Anmeldenummer: **83103296.6**

(22) Anmeldetag: **14.05.80**

(60) Veröffentlichungsnummer der früheren Anmeldung nach Art. 76 EPÜ: **0019802**

(51) Int. Cl.⁴: **H 05 K 3/28,** H 01 L 21/56, G 03 F 7/26, C 08 L 77/10, C 08 L 83/04

(54) Im Siebdruck verarbeitbare und wieder entfernbare Lötmaskenzusammensetzung und Verfahren zum Herstellen einer wieder entfernbaren Lötmaske.

(30) Priorität: **04.06.79 US 45524**

(43) Veröffentlichungstag der Anmeldung:
**04.01.84 Patentblatt 84/1**

(45) Bekanntmachung des Hinweises auf die Patenterteilung:
**27.08.86 Patentblatt 86/35**

(84) Benannte Vertragsstaaten:
**DE FR GB**

(56) Entgegenhaltungen:
**DE - A - 2 411 398**
**DE - A - 2 424 367**
**US - A - 3 179 635**
**US - A - 3 288 754**
**US - A - 3 781 237**

(73) Patentinhaber: **International Business Machines Corporation, Old Orchard Road, Armonk, N.Y. 10504 (US)**

(72) Erfinder: **Bakos, Peter, 530A Reuben Drive, Endicott New York 13760 (US)**
Erfinder: **Darrow, Russell Elwood, Rd. no. 1, Stratton Road, Newark Valley New York 13811 (US)**
Erfinder: **Rivenburgh, Dennis Louis, 804 Buffalo Road, Endicott New York 13760 (US)**
Erfinder: **Williams, William Francis, Rd. No. 2, Echo Road, Vestal New York 13850 (US)**

(74) Vertreter: **Kreidler, Eva-Maria, Dr. rer. nat., Schönaicher Strasse 220, D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine im Siebdruck verarbeitete und wieder entfernbare Lötmaskenzusammensetzung mit einem Gehalt an A) einem filmbildenden Polymeren in flüssiger Form, B) einem das Kleben verhindernden Mittel und C) einem festen, hochtemperaturbeständigen Füllstoff und ein Verfahren zum Herstellen einer wieder entfernbaren Lötmaske.

Die Erfindung ermöglicht, bestimmte Bereiche einer Unterlage durch die Lötmaske vor der Abscheidung eines Lotes zu schützen und gestattet die Entfernung der Lötmaske nach dem Abscheiden des Lotes. Die Lötmaskenzusammensetzung und das Verfahren zur Herstellung einer Lötmaske ist besonders wichtig bei der Herstellung mehrlagiger elektronischer Bauteile, bei denen eine Verbindung zwischen dem Träger oder der Unterlage und der integrierten Halbleiteranordnung oder dem Chip hergestellt werden soll. Die vorliegende Erfindung ist insbesondere anwendbar zur Herstellung von Produkten, bei denen mehr als ein Chip oder mehr als eine Halbleiteranordnung auf einem einzigen Träger oder Unterlage befestigt werden sollen.

Mehrlagige elektronische Bauelemente können hergestellt werden, indem man auf eine keramische Unterlage oder einen Träger eine Chromschicht, eine Kupferschicht und anschliessend wieder eine Chromschicht aufträgt. Danach wird eine Photoresistzusammensetzung aufgetragen, so dass bestimmte Bereiche der Chrom-/Kupfer-/Chromschichten entfernt werden können und die gewünschten elektrischen Verbindungen auf der Unterlage hergestellt werden können. Die oberste Chromschicht wird in bestimmten Bereichen mittels bekannter Ätzverfahren entfernt. Die oberste Chromschicht wird aufgetragen, damit das nachfolgend aufgebrachte Lot in denjenigen Bereichen, in denen das Chrom vorhanden ist, nicht an der Unterlage haftet. Anschliessend wird das freigelegte Kupfer in bestimmten Bereichen entfernt, wo sich Lot abscheiden soll, beispielsweise um die Löcher, in die nachfolgend Stifte eingeführt werden, und an Stellen, an denen die Halbleiterchips durch Auflöten mit der Unterlage verbunden werden. Die Kupferschicht bewirkt die elektrische Leitfähigkeit. Anschliessend werden die freiliegenden Bereiche der untersten Chromschicht durch Ätzen entfernt. Die unterste Chromschicht wird aufgetragen, um eine ausreichende Haftung zwischen der Kupferschicht und der Keramikunterlage zu gewährleisten. Nachdem die Eingangs-/Ausgangs-Stifte in die Unterlage eingeführt sind, wird Lot auf die Unterlage aufgetragen und auf den Eingangs-/Ausgangs-Stiften und den freiliegenden Kupferbereichen abgeschieden, jedoch nicht auf der Unterlage selbst und den freiwilligen Chrombereichen.

Bei diesem Verfahren treten Probleme dadurch auf, dass sich das Lot bei seiner Anwendung in kugelförmigen Niederschlägen auf den freiliegenden Bereichen abscheidet, und die Abscheidungen unterschiedliche Höhen haben. Dies spielt in den Bereichen eine Rolle, in denen anschliessend das Chip mit der Unterlage verbunden werden soll. Diese Bereiche werden im allgemeinen als Chip-Anschlussstellenbereiche bezeichnet. Durch die unebenen Abscheidungen in den Chip-Anschlussstellenbereichen können elektrische Kurzschlüsse und Fehler durch Wärmeübertragung auftreten. Das Lot wird auch auf die integrierten Schaltkreis-Chips selbst aufgetragen, dieser Überzug ist jedoch ein im wesentlichen einheitlicher und ebener Überzug, weil er durch Aufdampfen aufgetragen wird. Verfahren dieser Art sind nicht besonders zur Anwendung des Lots auf die Unterlage geeignet, weil Aufdampfverfahren relativ kostspielig sind und zu langsam für die Fertigung von Teilen in hoher Stückzahl. Ausserdem können die bei der Aufdampfung des Lots angewendeten hohen Temperaturen auch die Photomasken zerstören, wodurch die Photomaske ihre ursprüngliche Funktion, nämlich die Bereiche, in denen das Lot abgeschieden werden soll, abzugrenzen, nicht mehr erfüllt.

Die zuvor geschilderten Probleme werden durch das Verfahren gemäss der Erfindung vermieden. Erfindungsgemäss werden bestimmte Zusammensetzungen im Chip-Anschlussstellenbereich aufgetragen, um diese gegen eine Abscheidung des Lots auf freigelegtem Kupfer zu schützen. Nach der Entfernung der Zusammensetzung ist nur auf dem Chip Lot vorhanden, welches zur Verbindung des Chips mit der Unterlage benötigt wird, und dieses bildet, wie zuvor angegeben, einen ebenen Überzug. Dadurch wird eine einheitliche Höhe und eine erhöhte Zuverlässigkeit der Mehrlagenbauelemente erhalten. Weil ursprünglich auf dem Kupfer und dem Chip-Anschlussstellenbereich kein Lot vorhanden war, wird auch die Bindungsstärke zwischen Chip und Unterlage nicht negativ beeinträchtigt.

Eine Zusammensetzung, die für den zuvor angegebenen Zweck geeignet ist, muss eine Anzahl von Eigenschaften aufweisen, von denen einige anderen erforderlichen Eigenschaften zu widersprechen scheinen. Beispielsweise muss sich die Zusammensetzung genau auf den gewünschten Bereich, der vor dem Lot geschützt werden soll, auftragen lassen. Dazu ist es erforderlich, dass die Zusammensetzung eine bestimmte Fliess-Charakteristik aufweist.

Die Zusammensetzung muss gegenüber dem Lot unter den Bedingungen, unter denen dieses auf die Unterlage aufgetragen wird, widerstandsfähig sein. Ausserdem muss die Zusammensetzung hinreichend auf der Unterlage haften, so dass das Lot nicht unter dieser eindringt und mit denjenigen Kupferbereichen, die geschützt werden sollen, in Berührung kommt. Im Gegensatz zu dieser Haftung auf der Unterlage ist es jedoch erforderlich, dass die Zusammensetzung nicht so stark an der Unterlage haftet, dass eine nachfolgende Entfernung der Zusammensetzung unmöglich ist und/oder die Unterlage oder andere auf dieser befindliche Schichten zerstört werden.

Die Zusammensetzung, die leicht wieder entfernbar sein muss, muss hinreichend auf der Unterlage haften, damit sie für den vorgesehenen Verwendungszweck geeignet ist.

Die Bereitstellung von Zusammensetzungen mit allen zuvor beschriebenen Eigenschaften ist sehr schwierig. Die Auffindung geeigneter Zusammensetzungen wird auch dadurch erschwert, dass integrierte Schaltkreise viel komplexer werden und verschiedene Muster auf den Unterlagen sehr nahe aneinanderrücken und schwieriger herstellbar sind. Deshalb sind die Anforderungen an die gewünschte Zusammensetzung hinsichtlich der Herstellung von Mustern ganz besonders hoch.

Aus der deutschen Offenlegungsschrift 24 11 398 ist zwar eine photohärtbare Zusammensetzung für den Siebdruck mit einem Gehalt an einem Polyen, einem Polythiol und einem Silicon-Öl bekannt, die eine Zeit lang mit aktinischer Strahlung belichtet wird, bis das gesamte Polythiol mit Polyen reagiert hat, und der dann unter Ausschluss von Strahlung so viel Polythiol zugesetzt wird, dass mindestens 50% des anfänglich eingesetzten Polyens reagieren, so dass die Mischung eine bestimmte Viskosität aufweist. Die zuvor angegebene Zusammensetzung ist zur Beschichtung von Schaltkarten und Platten im Siebdruck geeignet, nach dem Härten durch aktinische Strahlung ist sie jedoch nicht mehr von der Unterlage entfernbar. Ausserdem enthält sie einen anderen Polymeranteil und keinen Füllstoff.

Aufgabe der Erfindung ist, eine Zusammensetzung anzugeben, mit der die Abscheidung eines Lots in bestimmten Bereichen, beispielsweise im Chip-Anschlussstellenbereich, auf einer Unterlage verhindert werden kann und die nach dem Löten leicht entfernbar ist.

Die Erfindung gemäss den Patentansprüchen löst diese Aufgabe. Gemäss dem Kennzeichen des Patentanspruchs 1 wird eine Lötmaskenzusammensetzung mit einem Gehalt an A) einem Polyimid/amid aus Pyromellithsäuredianhydrid und 4,4'-Diaminodiphenyläther, gelöst in N-Methyl-2-pyrrolidon, mit einer Viskosität von 0,025 bis 0,15 Pa. s bei 25°C; B) einem das Kleben verhindernden Mittel aus der Gruppe von flüssigem Siliconöl, Terpen, Terpineol, trockenem Öl und Mischungen derselben und C) einem festen, hochtemperaturbeständigen Füllstoff aus der Gruppe von gemahlenem Glas, Zinkoxid, Siliciumdioxid, Aluminiumoxid, Sand und Mischungen derselben bereitgestellt.

Durch die Erfindung werden grosse Lotmengen und dadurch hervorgerufene Kurzschlüsse im Chip-Anschlussstellenbereich und eine Flekkenbildung durch Flussmittel vermieden. Ausserdem wird eine ebene Fläche für die Ausrichtung der Chips und das Wiederaufschmelzen des Lotes geschaffen und die Grösse des Chip-Anschlussstellenbereichs nicht herabgesetzt. Die erfindungsgemässe Zusammensetzung lässt sich zu einem Muster mit hoher Auflösung verarbeiten und ist nach dem Löten ohne Rückstand von der Unterlage entfernbar.

In der Literatur sind Zusammensetzungen gemäss der Erfindung nicht beschrieben, und die kritische Kombination der Eigenschaften für den gewünschten Anwendungszweck wird durch den Stand der Technik auch nicht nähergelegt. Beispielsweise ist in der US Patentschrift 3 288 754 die Umsetzung eines reaktiven Silans mit einem Polyimid/amid angegeben. Im Gegensatz zu diesem Stand der Technik liegen in der vorliegenden Erfindung ein Siliconmaterial und ein Polyamid/imid in einer Mischung und nicht in einem Reaktionsprodukt vor. Wie nachfolgend noch im einzelnen beschrieben wird, reagiert das Silicon bei seiner Anwendung kaum mit dem Polyamid/imid und verdampft während des Verfahrens. Ausserdem werden in der Zusammensetzung gemäss der Erfindung bestimmte Mengen spezieller Füllstoffe verwendet, die in der US Patentschrift 3 288 754 nicht beschrieben sind.

In der US Patentschrift 3 781 237 wird eine Zusammensetzung mit einem Gehalt an Polyimid/amid und einem Polysiloxan beschrieben. Auch diese Patentschrift nimmt die vorliegende Erfindung nicht vorweg, weil die Menge an Polysiloxan sehr viel geringer ist als in der vorliegenden Erfindung.

In der US Patentschrift 3 440 203 ist eine Zusammensetzung beschrieben, welche ein Polyimid und Polysiloxan enthält. Auch in diesem Fall ist die Menge an Polysiloxan wesentlich niedriger als die in der vorliegenden Erfindung verwendete Menge.

Die vorliegende Erfindung betrifft eine im Siebdruck verarbeitbare und wieder entfernbare Lötmaskenzusammensetzung. Die Zusammensetzung enthält einen filmbildenden Polymeranteil in Form einer flüssigen Zusammensetzung, wobei das Polymere ein Polyimid/amid ist. Die Zusammensetzung enthält auch ein das Kleben verhinderndes Mittel, welches mit dem Polymer verträglich ist und ein flüssiges Siliconöl und/oder ein Terpen und/oder ein Terpineol und/oder ein trocknendes Öl ist. In der Zusammensetzung ist auch ein fester, hochtemperaturbeständiger Füllstoff vorhanden, der in einer solchen Menge angewendet wird, dass sich die Zusammensetzung nach dem Löten von der Unterlage wieder entfernen lässt. Das Verhältnis von Polymer im Polymerteil zu dem das Kleben verhindernden Mittel liegt zwischen 2:1 und 1:3. Das zuvor angegebene Verhältnis zwischen Polymerkomponente und dem Mittel, das das Kleben verhindert, basiert auf der Gesamtmenge an Polymer in dem Polymeranteil und dem Mittel, das das Kleben verhindert und schliesst beispielsweise etwa vorhandene Mengen an Lösungsmittel, die das Polymer in eine flüssige Polymerzusammensetzung überführen, nicht ein.

Die vorliegende Erfindung betrifft auch ein Verfahren zum Herstellen einer wieder entfernbaren Lötmaske, mit der bestimmte Bereiche der Unterlage vor der Einwirkung eines Lots während der Lötoperation geschützt werden können.

Das erfindungsgemässe Verfahren betrifft das Aufbringen einer Lötmaskenzusammensetzung im Siebdruck auf eine Unterlage in einem bestimmten Muster. Die beschichtete Unterlage wird zur Härtung der Zusammensetzung getrocknet. Anschliessend wird ein Lot aufgetragen, wobei das Lot in denjenigen Bereichen, die durch die gehärtete Lötmaske bedeckt sind, nicht an der Unterlage haftet. Nach der Einwirkung des Lots wird die Lötmaske von der Unterlage entfernt. Die im Siebdruck verarbeitbare und wieder entfernbare Lötmaskenzusammensetzung gemäss der vorliegenden Erfindung enthält einen filmbildenden Polymeranteil in Form einer flüssigen Zusammensetzung, ein Mittel, das Kleben verhindert, und einen festen, hochtemperaturbeständigen Füllstoff.

Der filmbildende Polymeranteil der Zusammensetzung ist ein Polyimid/amid-Polymer. Der Polyimid/amid-Polymeranteil der Zusammensetzung muss in Form einer flüssigen Zusammensetzung vorliegen. Dementsprechend kann der Polymeranteil eine Lösung oder eine Dispersion des Polyimid/amids in einem nichtreaktiven Lösungsmittel sein.

Die Polyimid/amid-Polymeren, die erfindungsgemäss verwendet werden, sind gut bekannt und im Handel erhältlich. Polymere dieser Art werden in der Literatur manchmal als Polyamide oder Polyamidsäuren bezeichnet und stellen tatsächlich nicht voll ausgehärtete Polymere dar, welche wechselnde Mengen von Amid- und Imidgruppierungen entlang der Polymerkette enthalten. Die Imidgruppen werden durch Kondensation der Amidform mit einer Säuregruppe der Polymerkette gebildet. Polymere dieser Art werden im allgemeinen hergestellt durch Reaktion wenigstens eines Diamins mit wenigstens einer Polycarbonsäure und/oder eines Anhydrids derselben und/oder eines Esters derselben. Beispiele für verschiedene Polyimide/amide können den US Patentschriften 2 710 853, 2 712 543, 2 731 447, 2 880 230, 3 037 966, 3 073 784, 3 073 785, 3 179 631, 3 179 632, 3 179 633, 3 179 634, 3 179 635 und 3 190 856 entnommen werden. Die bevorzugten Imid/amid-Polymeren, die erfindungsgemäss verwendet werden, sind diejenigen, die durch Reaktion eines aromatischen Diamins mit einem aromatischen Tetracarbonsäure-dianhydrid erhalten werden.

Beispiele einiger Anhydride, die zur Herstellung des Polyimid/amids verwendet werden können, sind Pyromellithsäure-dianhydrid; Mellithsäure-anhydrid; Trimellithsäure-anhydrid; 2, 3, 6, 7-Naphthalintetracarbonsäure-dianhydrid; 1,2,5,6-Naphthalintetracarbonsäure-dianhydrid; 3,3′,4,4′-Diphenyltetracarbonsäure-dianhydrid; 2,2′,3,3′-Diphenyltetracarbonsäure-dianhydrid; 3,3′,4,4′-Diphenylmethantetracarbonsäure-dianhydrid; Bis(3,4-carboxyphenyl)äther-dianhydrid; Bis(2,3-dicarboxyphenyl)sulfon-dianhydrid; 3,3′,4,4′-Benzophenontetracarbonsäure-dianhydrid; 3,3′,4,4′-Stilbentetracarbonsäure-dianhydrid; 2,3,6,7-Anthracentetracarbonsäure-dianhydrid; 1,2,7,8-Phenanthrentetracarbonsäure-dianhydrid; 2,3,6,7-Naphthacentetracarbonsäuredianhydrid; 2,3,8,9-Chrysentetracarbonsäuredianhydrid; 2,3,6,7-Triphenylentetracarbonsäure-dianhydrid; Pyren-4,5,9,10-tetracarbonsäure-dianhydrid; Perylen-3,4,9,10-tetracarbonsäure-dianhydrid und Coronen-1,2,7,8-tetracarbonsäure-dianhydrid.

Beispiele einiger aliphatischer organischer Diamine sind Äthylendiamin; N-Methyläthylendiamin; Trimethylendiamin; Tetramethylendiamin; 1,5-Diaminopentan; Hexamethylendiamin; 1,4-Diaminocyclohexan; 1,3-Diaminocyclopentan; 1,3-Diamino-2-methylpropan; 1,6-Diamino-4-methylhexan; 1,4-Diamino-2-methyl-butan; 1-(N-Propylamino)-6-aminohexan und 1,3-Diamino-2-phenylpropan.

Beispiele einiger aromatisch-aliphatischer Diamine sind p-Aminophenylmethylamin und m-Aminophenylmethylamin. Beispiele einiger aromatischer organischer Diamine sind 2,2-Di-(4-aminophenyl)propan; 4,4′-Diaminodiphenylmethan; Benzidin; Mono-N-methylbenzidin; 3,3′-Dichlorbenzidin; 4,4-Diaminodiphenylsulfid; 3,3′-Diamindiphenylsulfon; 4,4′-Diaminodiphenylsulfon; 4,4′-Diaminodiphenyläther; 1,5-Diaminonaphthalin; m-Phenylendiamin; p-Phenyldiamin; 3,3′-Dimethyl-4,4′-biphenyldiamin; 3,3′-Dimethoxybenzidin; 1-Isopropyl-2,4-phenylendiamin; 3,5-Diamino-o-xylol; 3,5-Diaminodiphenyl; 1,3-Diaminonaphthalin; 2,6-Diaminoanthracen und 4,4′-Diaminostilben. Die am meisten bevorzugten aromatischen Diamine sind 4,4′-Diaminodiphenyläther, 4,4′-Diaminodiphenylmethan und p-Phenylendiamin.

Die Polyimide/amide, die erfindungsgemäss verwendet werden, haben im allgemeinen Molekulargewichte von etwa 500 bis etwa 2500 und, wenn sie nur mit dem Verdünnungsmittel gemischt sind, vorzugsweise eine Viskosität von 0,025 bis 0,15 Pa.s bei normaler Zimmertemperatur (etwa 25°C). Die Polyimide/amide, die als feste Polymermaterialien vorliegen, werden mit einem inerten Verdünnungsmittel vor dem Zusatz zu den anderen Bestandteilen der Zusammensetzung gemischt. Beispiele einiger inerter Verdünnungsmittel, welche nicht mit den Diaminen oder Dianhydriden, die zur Herstellung der Polyimide/amide verwendet werden oder mit dem Reaktionsprodukt reagieren, schliessen organische polare Lösungsmittel ein, welche ein Dipolmoment aufweisen und deren funktionelle Gruppen nicht mit den Vorläufern (d.h. den Diaminen oder Dianhydriden) reagieren. Beispiele einiger geeigneter organischer polarer Lösungsmittel schliessen N,N-Dimethylformamid; N,N-Dimethylacetamid; N-Methyl-2-pyrrolidon; N,N-Diäthylformamid; N,N-Diäthylacetamid; N,N-Dimethylmetxyacetamid; Dimethylsulfoxid; Diäthylsulfoxid; Pyridin; Dimethylsulfon; Diäthylsulfon; Dipropylsulfon; Hexamethylphosphoramid; Tetramethylensulfon; Dimethyltetramethylensulfon und Dimethoxytetramethylensulfon ein. Wenn es gewünscht wird, können auch Mischungen der Verdünnungsmittel verwendet werden. Darüber hinaus können die zuvor genannten Verdünnungsmittel in Kombination mit einer geringen Menge eines Nicht-Lösungsmittels wie Benzol, Benzonitril, Dioxan, Butyrolacton, Xylol, Toluol und Cyclohexan verwendet werden unter der Voraussetzung, dass das Polymer durch die Lösungsmittelkombination in flüssige Form überführt wird. Bevorzugtes Verdünnungsmittel zur Verwendung mit dem Polyimid/amid ist N-Methyl-2-pyrrolidon. Die Menge des verwendeten Verdünnungsmittels, bezogen auf die Menge an Polyimid/amid wird so gewählt, dass eine Zusammensetzung aus Polyimid/amid und Verdünnungsmittel erhalten wird, welches eine Viskosität von etwa 0,025 bis 0,15 Pa.s bei etwa 25°C aufweist. Im allgemeinen wird das Polyimid/amid in Mengen von etwa 5 bis 35 Gewichtsprozent verwendet und das Verdünnungsmittel entsprechend in Mengen von etwa 95 bis 65 Gewichtsprozent, wobei diese relativen Mengen auf den Gesamtgehalt an Polyimid/amid und Verdünnungsmittel bezogen sind.

Die Zusammensetzung muss auch einen Bestandteil enthalten, der das Kleben verhindert, der aber mit dem Polymeranteil der Zusammensetzung verträglich ist. Dieses Mittel reduziert die Klebrigkeit der Zusammensetzung, wodurch sie sich im Siebdruckverfahren, das zum Auftragen der Zusammensetzungen in einem vorbestimmten Muster auf Unterlagen angewendet wird, leichter auftragen lässt. Dies ist besonders wichtig, weil bei zunehmender Feinheit der Siebe die Kontrolle der Klebrigkeit und auch der Viskosität an Bedeutung zunimmt.

Das Mittel, welches das Kleben der Zusammensetzung verhindert, dient auch zur Einstellung der Viskosität, damit die gewünschte Viskosität der Zusammensetzung für den Siebdruck erhalten wird und damit die im Siebdruck verarbeitbare Zusammensetzung, insbesondere für den beabsichtigten Zweck der vorliegenden Erfindung, bei der Herstellung von elektronischen Schaltungen geeignet ist. Was das Nichtklebrigsein anbetrifft, so darf die Zusammensetzung bei ihrem Auftrag nicht am Sieb kleben bleiben, sonst findet eine Verformung des Musters statt bei der Entfernung von der Unterlage.

Das Mittel, das das Kleben der Zusammensetzung verhindert, wird tatsächlich während des Trocknens und/oder der Lötoperation durch Zersetzung und Verdampfung entfernt. Das Mittel, das das Kleben verhindert, sollte nicht in unerwünschtem Masse verkohlen und einen Rückstand auf der Unterlage zurücklassen, der im nachfolgenden Reinigungs- und Entfernungsverfahren schwierig zu entfernen ist.

Es wurde gemäss der vorliegenden Erfindung gefunden, dass, wenn das Polymer des filmbildenden Polymeranteils ein Polyimid/amid ist, dass das Kleben verhindernde Mittel ein flüssiges Siliconöl, ein trocknendes Öl, ein Terpen oder ein Terpineol sein kann. Wenn es gewünscht wird, können auch Mischungen dieser bestimmten, das Kleben verhindernden Mittel angewendet werden, solange sie untereinander verträglich sind. Die das Kleben verhindernden Mittel, die erfindungsgemäss verwendet werden, weisen im allgemeinen Viskositäten von etwa 0,025 bis 0,5 Pa.s bei 25°C auf.

Die flüssigen Siliconöle, die erfindungsgemäss verwendet werden können, sind gut bekannte Materialien. Beispielsweise enthalten viele Silicone zwei oder mehr Siloxaneinheiten, wie aus der nachfolgenden Formel einer mittleren Einheit ersichtlich ist.

$$[OH]_x \, [OR_1]_y \, [R]_z \, SiO \, \frac{4-x-y-z}{2}$$

Im einzelnen ist jeder Rest R ein Alkyl-, Cycloalkyl-, Alkenyl-, Aryl-, Aralkyl- oder Cycloalkenyl-Rest, ein halogeniertes Derivat der zuvor angegebenen Reste und ein Cyanalkyl-Rest. $OR_1$ ist ein Alkoxy- oder Acyloxy-Rest. Wenn es gewünscht wird, können auch Mischungen der oben definierten Reste R und OR1 angewendet werden.

Im allgemeinen hat x einen Wert von etwa 0 bis 1, y einen Wert von etwa 0 bis 1 und die Summe x + y einen Wert von etwa 0 bis 1 und z einen Wert von etwa 1 bis 2.

Der Rest R wird vorzugsweise gewählt aus einer Gruppe von Niedrigalkyl-Resten mit 1 bis 18 Kohlenstoffatomen; aus Cycloalkyl-Resten mit 5 bis 7 Kohlenstoffatomen in Ring; Niedrigalkyl-Resten mit 2 bis 8 Kohlenstoffatomen; einkernigen Aryl-Resten; einkernigen Aryl-Niedrigalkyl-Resten mit 1 bis 6 Kohlenstoffatomen in der Alkylgruppe; Cycloalkenyl-Resten mit 5 bis 7 Kohlenstoffatomen im Ring und halogenierten Derivaten dieser Reste.

Im einzelnen wird R gewählt aus der Klasse der Niedrigalkyl-Reste, d.h. aus Resten wie Methyl, Äthyl, Propyl, Butyl, Octyl und Octadecyl; aus Cycloalkyl- und Cycloalkenyl-Resten mit 5 bis 7 Kohlenstoffatomen im Ring, d.h. aus Cyclopentyl, Cyclohexyl, Cycloheptyl und Cyclohexenyl-Resten; aus Niedrigalkenyl-Resten, d.h. aus Vinyl- und Allyl-Resten; aus einkernigen Aryl-Resten, d.h. aus Phenyl, Tolyl und Xylyl-Resten; aus einkernigen Aryl-Niedrigalkyl-Resten, d.h. aus Benzyl- und Phenyläthyl-Resten; halogenierten Derivaten der zuvor angegebenen Reste und Cyanalkyl-Resten, d.h. aus Chlormethyl, β-Chloräthyl, Chlorphenyl, Dibromphenyl und Trifluormethyläthyl-Resten. Vorzugsweise wird R gewählt aus der Klasse von Methyl, Äthyl und Phenyl.

Der Alkoxy-Rest OR1 wird gewählt aus der Klasse der Niedrigalkoxy-Reste mit 1 bis 8 Kohlenstoffatomen, d.h. aus Methoxy, Äthoxy, Propoxy und Isopropoxy-Resten. Der Acyl-Rest $R_1CO$ ist ein Acyl-Rest einer gesättigten aliphatischen Monocarbonsäure wie Formyl, Acetyl, Propionyl, Butyryl, Hexoyl, 2-Äthylhexoyl, Octanoyl, Isovaleryl und Stearyl, wobei Acetyl bevorzugt wird. Es sei auch bemerkt, dass Copolymere, welche zwei oder mehr verschiedene Siloxaneinheiten enthalten, verwendet werden können. Als Endgruppen können in den Siliconflüssigkeiten diejenigen, welche zur Blockierung von Endgruppen bei Siliconpolymeren bekannt sind, verwendet werden. Als bevorzugte Siliconflüssigkeiten gemäss der vorliegenden Erfindung kommen flüssige Polydimethylsiloxane und insbesondere solche, bei denen beide Enden des Polymeren mit drei Methylgruppen besetzt sind, in Frage. Die Anzahl der sich wiederholenden Einheiten des Silicons wird so gewählt, dass eine Viskosität der Siliconzusammensetzung im Bereich von etwa 0,05 bis 0,5 Pa.s bei 25°C erhalten wird. Die Viskosität soll vorzugsweise bei etwa 0,1 bis 0,3 Pa.s. liegen.

Eine andere Klasse der das Kleben verhindernden Mittel, welche erfindungsgemäss verwendet werden können, wenn das filmbildende Polymer ein Polyimid/amid ist, umfasst die trocknenden Öle. Die Verwendung trocknender Öle schliesst natürliche trocknende Öle ein, die bekannt sind als Glyceride von Fettsäuren, welche zwei oder mehr Doppelbindungen erhalten, wobei durch Aussetzen an Luft der Luftsauerstoff absorbiert werden kann unter Erhalt von Peroxiden, welche die ungesättigten Teile katalisieren. Eingeschlossen sind auch die Glyceride der äthylenisch ungesättigten Fettsäuren dieser Öle selbst und andere natürliche und synthetische äthylenisch ungesättigte Ester mit ähnlichen Eigenschaften.

Als das Kleben verhinderndes Mittel gemäss der vorliegenden Erfindung können bei Verwendung von Polyimid/amid als filmbildendes Polymer auch Terpene, beispielsweise Terpentin, verwendet werden. Als das Kleben verhinderndes Mittel können auch eines oder mehrere der Terpineole, beispielsweise α-Terpineol verwendet werden.

Wenn es gewünscht wird, können auch Mischungen der verschiedenen Mittel zur Verhinderung des Klebens verwendet werden, unter der Voraussetzung, dass sie untereinander und mit dem speziell verwendeten Polymer verträglich sind.

Als das Kleben verhinderndes Mittel muss ein solches verwendet werden, das im wesentlichen aus der Zusammensetzung während des Trocknens und/oder Lötens durch Zersetzung oder Verdampfung entfernt wird. Es sollte auch nicht im grösseren Ausmass verkohlen und einen unerwünschten Rückstand auf der Oberefläche der Unterlage zurücklassen, welcher anschliessend schwierig zu entfernen ist.

Die im Siebdruck verarbeitbare und wieder entfernbare Lötmaskenzusammensetzung der vorliegenden Erfindung enthält auch einen festen Füllstoff. Der feste Füllstoff muss erhöhten Temperaturen ausgesetzt werden können. Insbesondere muss er gegen erhöhte Temperaturen, die beim Aufbringen des heissen Lotes auftreten, beständig sein und wenigstens etwa 300°C und vorzugsweise wenigstens etwa 350°C aushalten. Das Lot wird im allgemeinen bei Temperaturen zwischen etwa 300 und 400°C aufgetragen. Beispiele einiger geeigneter fester, hochtemperaturbeständiger Füllstoffe schliessen gemahlenes Glas, Zinkoxid, Siliciumdioxid, Aluminiumoxid, Diamantenstaub und die hochtemperaturbeständigen Sandsorten ein.

Der verwendete Füllstoff hat im allgemeinen eine Teilchengrösse von etwa 0,1 bis etwa 20 μm und vorzugsweise von etwa 0,1 bis 5 μm. Es ist wesentlich, dass der Füllstoff eine feine Teilchengrösse besitzt, damit er sich für die Herstellung mehrlagiger elektronischer Schaltkreise eignet. Die Menge des Füllstoffs wird so gewählt, dass die Zusammensetzung leicht nach ihrer Verwendung von der Unterlage, beispielsweise durch blosses Waschen entfernt werden kann. Es wird angenommen, dass der Füllstoff dazu neigt, die Polymerisation oder die Vernetzung des filmbildenden Materials zu Molekülen von sehr grossem Molekulargewicht zu verzögern, wodurch verhindert wird, dass das Polymer zu zäh an der Unterlage haftet. Andererseits müssen der Typ, die Grösse und die Menge des Füllstoffs so gewählt werden, dass die Bindung zwischen der Unterlage und der Zusammensetzung nicht in dem Masse zerstört wird, das eine Verwendung der Zusammensetzung als Lötsmaske ausgeschlossen ist. Die Zusammensetzung sollte auch im wesentlichen, wenn nicht ganz, frei von Härtungsmitteln für die Polymeren der Zusammensetzung sein.

Die erfindungsgemäss verwendeten Zusammensetzungen weisen im allgemeinen eine Viskosität von etwa 7,0 bis 15,0 Pa.s bei 25°C auf. Bevorzugte Viskositäten der Zusammensetzungen liegen zwischen etwa 1,0 und 1,3 und besonders bevorzugte zwischen etwa 7,0 bis etwa 12,5 Pa.s bei 25°C.

Das Verhältnis des filmbildenden Polymers im Polymeranteil der Zusammensetzung relativ zu dem das Kleben verhindernden Mittel liegt im allgemeinen zwischen etwa 2:1 und 1:3 und vorzugsweise zwischen etwa 1:1 und 2:3. Das Verhältnis von Füllstoff relativ zu der filmbildenden Polymerkomponente des Polymeranteils der Zusammensetzung liegt zwischen etwa 1:6 bis 6:1 und vorzugsweise bei etwa 2:1 bis 6:1. Die Zusammensetzung darf mit dem Lot unter dessen Anwendungsbedingungen nicht mischbar sein. Es sollten auch die Bestandteile der Zusammensetzung miteinander verträglich sein.

Ein typisches Verfahren für die Anwendung der im Siebdruck verarbeitbaren und wieder entfernbaren Lötmaskenzusammensetzung gemäss der vorliegenden Erfindung umfasst das Auftragen der Lötzusammensetzung auf eine Unterlage, beispielsweise auf ein keramisches Substrat in einem bestimmten Bereich, in dem der integrierte Schaltkreis-Chip anschliessend befestigt wird. Ein keramisches Material wird hergestellt durch die Einwirkung von Hitze auf bestimmte Erden als Rohmaterial. Bevorzugte keramische Unterlagen enthalten Siliciumdioxid und Silicate, wie Aluminiumsilicat und Aluminiumoxide.

Die Unterlagen können vorgebildete Löcher enthalten, durch die Eingangs- und Ausgangs-Stifte eingeführt werden können, die aus einer Oberfläche der Unterlage hervorragen und die zur Befestigung an Schaltkreiskarten oder Platten dienen. Die Stifte ragen auch ganz geringfügig aus der anderen Oberfläche, die als Rückseite bezeichnet wird, heraus, so dass sie mit der Schaltung auf der Rückseite in Kontakt sind, die ihrerseits eine Verbindung zwischen dem integrierten Schaltkreis-Chip, welches auf die Rückseite der Unterlage aufgetragen wird, herstellt. Der Bereich, der vor dem Lot geschützt und abgeschirmt werden soll, wird durch Anwendung eines Siebdruckverfahrens bestimmt. Der Überzug wird im allgemeinen auf die Unterlage in Schichtdicken von etwa 0,025 mm bis 0,635 mm, vorzugsweise von etwa 0,127 mm bis etwa 0,25 mm und insbesondere bevorzugt in einer Schichtdicke von etwa 0,051 mm bis etwa 0,076 mm aufgetragen.

Die beschichteten Unterlagen werden dann getrocknet, um eine Härtung der Überzugszusammensetzung zu bewirken. Das Trocknen wird im allgemeinen bei etwa 50 bis 150°C durchgeführt und ist nach etwa 10 bis 30 Minuten abgeschlossen. Dieser Schritt kann auch bis zu einem gewissen Grad, wenn auch nicht vollständig, die Zersetzung und Verdampfung des das Kleben verhindernden Mittels der Zusammensetzung bewirken. Die Unterlagen werden dann mit Stiften versehen unter Verwendung der hierfür üblichen Vorrichtungen. Weniger vorzuziehen ist, die Unterlagen vor Auftragen der Beschichtung mit Stiften zu versehen. Nach dem Anbringen der Stifte und dem Härten der Überzugszusammensetzung werden die Unterlagen mit Lötzinn versehen oder mit dem Lot einem Tauchbeschichter oder mittels einer Lötwelle versehen. Während des Lötens oder Verzinnens sind die Bereiche, die mit einer Lötmaske bedeckt sind, vor dem Lot geschützt. Das Lot oder Zinn haftet nur an dem freiliegenden Kupfer der Unterlagen, d.h. an den Stiften und in den Bereichen um dieselben. Das Zinn oder Lot wird im allgemeinen bei Temperaturen zwischen 300 und 400°C aufgetragen. Während des Lötens zersetzt sich das noch vorhandene Mittel zum Verhindern des Klebens und verdampft.

Nach dem Abschrecken der gelöteten Unterlage und den damit verbundenen schnellen Temperaturwechsel und der Kontraktionsunterschiede zwischen Unterlage und Zusammensetzung bricht die Maskenzusammensetzung und löst sich von der Unterlage. Irgendwelche noch zurückbleibende Maskenzusammensetzung kann von der Unterlage durch leichtes Bürsten und/oder durch kurzzeitiges Anwenden eines Lösungsmittels wie N-Methyl-2-pyrrolidon oder Trichloräthylen oder Perchloräthylen entfernt werden. Der Kontakt mit den Lösungsmitteln sollte herbeigeführt werden, während die Unterlage sich auf einer Temperatur zwischen 100 und 180°C befindet und zwar etwa 10 Sekunden bis 2 Minuten nach Beendigung der Lötoperation. Der Kontakt mit den Lösungsmitteln dauert im allgemeinen etwa 4 Sekunden bis etwa 60 Sekunden und vorzugsweise etwa 4 bis etwa 25 Sekunden. Das Lösungsmittel kann auf die Unterlage aufgesprüht werden, beispielsweise bei Drucken von etwa 0,7 bis 5,62 daN/cm² und vorzugsweise von 2,11 bis 4,22 daN/cm². Wenn es gewünscht wird, kann die Unterlage auch bewegt werden, beispielsweise mit etwa 20 bis 30 Schwingungen mit einer seitlichen Auslenkung von etwa 1,27 bis 5,08 mm oder bei 120 bis 160 Schwingungen mit einer seitlichen Auslenkung von etwa 0,127 bis 0,635 mm, wodurch die Entfernung von Teilchen bewirkt wird. Weiterhin kann ein Luftstrahl auf die Unterlagen gerichtet werden und in verstärktem Masse die Entfernung irgendwelcher Teilchen, die von der Lötmaske zurückbleiben, bewirken. Es sei bemerkt, dass, wenn die Unterlagen vor Entfernung der Lötmaskenzusammensetzung durch Einwirkung der Lösungsmittel auf Zimmertemperatur abgekühlt werden, es erforderlich ist, die Unterlagen wieder mit einem Lötflussmittel und Lötzinn zu versehen und dann abzuschrecken, um die Entfernung der Lötmaskenzusammensetzung zu diesem Zeitpunkt des Verfahrens zu erleichtern.

Das Löten wird im allgemeinen nach etwa 5 bis 25 Sekunden abgeschlossen. Die Unterlagen sind dann für weitere Verfahrensschritte bereit, beispielsweise für die Belegung mit den gewünschten integrierten Schaltkreis-Chips, wobei nur das Lot auf dem Chip zur Befestigung an der Unterlage dient im Gegensatz zum Stand der Technik, nach dem beide, Chip und Unterlage, Lot enthalten. Wie zuvor beschrieben, bietet die Erfindung eine Reihe wesentlicher Vorteile, insbesondere bei der Herstellung von mehrlagigen Schaltungen unter Verwendung integrierter Schaltkreise. Einige Vorteile sind die Eliminierung einer hohen Menge an Lot zwischen Chip und Anschlussstelle, die Eliminierung von Kurzschlüssen im Chip-Anschlussstellenbereich, die Vermeidung von Lötflussmittelflecken im Chip-Anschlussstellenbereich, die Vermeidung einer Chromabscheidung oder eines Kurzschlusses im Chip-Anschlussstellenbereich, die Bereitstellung einer ebenen Fläche für die Chip-Ausrichtung und das Aufschmelzen des Lotes und die Vermeidung der Verkleinerung der Chip-Anschlussstelle. Beispielsweise wird normalerweise während der Lötoperation eine endliche Menge Kupfer in dem Lot gelöst. Dementsprechend reduziert diese Entfernung von Kupfer die Kupfermenge im Anschlussstellenbereich.

Die Erfindung wird anhand der nachfolgenden Ausführungsbeispiele näher erläutert.

Beispiel 1

Eine Zusammensetzung, die etwa 10 Gewichtsteile eines Polyimid/amidharzes aus Pyromellithsäuredianhydrid und 4,4'-Diaminodiphenyläther, das im Handel unter der Warenbezeichnung AI 10 von Amoco erhältlich ist; etwa 30 Gewichtsteile N-Methyl-2-pyrrolidon; etwa 12 Gewichtsteile Polydimethylsiloxan, dessen Enden mit Methylgruppen blockiert sind und das eine Viskosität von etwa 0,2 Pa.s aufweist und von Dow Corning unter der Handelsbezeichnung Fluide Nr. 200 erhältlich ist, und etwa 48 Gewichtsteile Zinkoxid mit einer Teilchengrösse von etwa 1 μm enthält, wird gemischt.

Die Zusammensetzung wird im Siebdruck auf eine mit Kupfer beschichtete keramische Unterlage aufgetragen und etwa 25 Min. lang bei etwa 150°C getrocknet. Nachdem die Unterlage mit den Eingangs- und Ausgangs-Stiften versehen ist, wird die Unterlage einer Lötoperation unterworfen unter Verwendung eines Zinn-/Blei-Lotes (90:10) während 15 Sekunden bei 360°C. Die Unterlagen werden dann auf eine Temperatur von etwa 150°C abgeschreckt und 30 bis 45 Sekunden lang in heisses N-Methyl-2-pyrrolidon (60 bis 85°C) getaucht, um eine vollständige Entfernung des Überzugs zu gewährleisten. Ein integriertes Halbleiterchip aus Silicium, welches mit Lötmittel versehen ist, wird im Chip-Anschlussbereich auf die Unterlage aufgebracht und durch Aufschmelzen des Lotes befestigt. Als Ergebnis wird eine ebene Anschlussstelle zwischen Chip und Unterlage erhalten. Tests, mit denen die Zugkraft festgestellt wird, die zur Entfernung des Chips von der Anschlussstelle erforderlich ist, zeigen an, dass die Zugkraft die gleiche ist wie bei einem Standardverfahren, bei dem sowohl das Chip wie auch die Anschlussstelle Lot enthalten. Die Zusammensetzung weist eine sehr gute Flexibilität auf.

Beispiel 2

Das allgemeine Verfahren, das in Beispiel 1 beschrieben ist, wird wiederholt mit der Ausnahme, dass die Zusammensetzung etwa 10 Gewichtsteile Polyimid/amid; etwa 25 Gewichtsteile N-Methyl-2-pyrrolidon; etwa 15 Gewichtsteile Polydimethylsiloxan des Typs, der in Beispiel 1 verwendet wird, und etwa 50 Gewichtsteile gemahlenen Glases mit einer Teilchengrösse von etwa 5 µm enthält. Es werden ähnliche Ergebnisse wie in Beispiel 1 erhalten.

Beispiel 3

Das allgemeine Verfahren von Beispiel 1 wird wiederholt mit der Ausnahme, dass die Zusammensetzung hergestellt wird, indem eine Mischung mit einem Gehalt von 16 Gewichtsteilen Polyimid/amid und etwa 84 Gewichtsteilen N-Methyl-pyrrolidon mit einer Mischung aus etwa 15 Gewichtsteilen Glaspulver mit einer Teilchengrösse von etwa 2 bis 3 µm und 45 Gewichtsteilen α-Terpineol kombiniert wird. Das Glaspulver und das α-Terpineol werden vor der Zugabe zu dem Polyimid/amid in einer Kugelmühle 24 Stunden vorgemischt, um eine einheitliche Mischung zu gewährleisten. Die Mischung aus Polyimid/amid und N-Methyl-pyrrolidon ist im Handel unter der Handelsbezeichnung PI 2550 von Du Pont erhältlich. Dann wird die zuvor angegebene Mischung weitere 24 Stunden lang in einer Kugelmühle gemahlen, um eine einheitliche Zusammensetzung zu gewährleisten. Es werden ähnliche Ergebnisse wie in Beispiel 1 erhalten.

Beispiel 4

Das allgemeine Verfahren von Beispiel 1 wird wiederholt mit der Ausnahme, dass die anzuwendende Zusammensetzung hergestellt wird aus einer Mischung von etwa 16 Gewichtsteilen Polyimid/amid und etwa 84 Gewichtsteilen N-Methyl-pyrrolidon des Typs, der in Beispiel 3 verwendet wird, und einer Mischung von etwa 3 Gewichtsteilen Cabosil (Silica-aerogel) mit einer Teilchengrösse von etwa 1 bis etwa 5 µm und 30 Gewichtsteilen α-Terpineol. Das Cabosil und α-Terpineol werden zusammen etwa 8 bis 12 Stunden bei 25°C in einer Kugelmühle gemahlen vor der Zugabe zu der Polyimid/amid-Zubereitung. Die Gesamtmischung wird weitere 12 bis 24 Stunden in einer Kugelmühle gemahlen, um eine entsprechende Vermischung zu gewährleisten. Es werden ähnliche Ergebnisse wie in Beispiel 1 erhalten.

Beispiel 5

Das allgemeine Verfahren von Beispiel 1 wird wiederholt mit der Ausnahme, dass eine Zusammensetzung, welche aus einer Mischung von etwa 16 Gewichtsteilen Polyimid/amid und etwa 84 Gewichtsteilen N-Methyl-2-pyrrolidon des Typs, der in Beispiel 3 verwendet wird und einer Mischung aus etwa 10 Gewichtsteilen Aluminiumoxid mit einer Teilchengrösse von etwa 10 µm und etwa 30 Gewichtsteilen α-Terpineol hergestellt wird, verwendet wird. Das Aluminiumoxid und das α-Terpineol werden 8 bis 12 Stunden lang in einer Kugelmühle vorgemischt. Danach wird die Zusammensetzung weitere 12 bis 24 Stunden lang in einer Kugelmühle gemahlen, um eine einheitliche Mischung zu gewährleisten. Es werden ähnliche Ergebnisse wie in Beispiel 1 erhalten.

Beispiel 6

Das allgemeine Verfahren, das in Beispiel 4 beschrieben ist, wird wiederholt mit der Ausnahme, dass die verwendete Zusammensetzung hergestellt wird aus einer Mischung von etwa 16 Gewichtsteilen Polyimid/amid und etwa 84 Gewichtsteilen N-Methyl-2-pyrrolidon des Typs, der in Beispiel 3 verwendet wird, und einer Mischung von etwa 15 Gewichtsteilen Zinkoxid mit einer Teilchengrösse von etwa 10 µm und etwa 30 Gewichtsteilen α-Terpineol. Die Mischung des Zinkoxids mit dem Terpineol wird vor der Zumischung der Polyimid/amid-Zusammensetzung etwa 18 bis 24 Stunden lang in einer Kugelmühle gemahlen. Danach wird die Gesamtzusammensetzung für weitere 12 bis 24 Stunden in der Kugelmühle gemahlen. Es werden ähnliche Ergebnisse wie in Beispiel 1 erhalten.

**Patentansprüche**

1. Im Siebdruck verarbeitbare und wieder entfernbare Lötmaskenzusammensetzung mit einem Gehalt an A) einem filmbildenden Polymeren in flüssiger Form, B) einem das Kleben verhindernden Mittel und C) einem festen, hochtemperaturbeständigen Füllstoff, dadurch gekennzeichnet, dass das filmbildende Polymere A ein Polyimid/amid aus Pyromellithsäuredianhydrid und 4,4'-Diamino-diphenyläther, gelöst in N-Methyl-2-pyrrolidon, mit einer Viskosität der Lösung von 0,025 bis 0,15 Pa.s bei 25°C ist; das das Kleben verhindernde Mittel B) gewählt ist aus der Gruppe von flüssigem Siliconöl, Terpen, Terpineol, trocknendem Öl oder Mischungen derselbe und der feste hochtemperaturbeständige Füllstoff C) gewählt ist aus der Gruppe von gemahlenem Glas, Zinkoxid, Siliciumdioxid, Aluminiumoxid, Sand und Mischungen derselben.

2. Lötmaskenzusammensetzung nach Anspruch 1, dadurch gekennzeichnet, dass das Verhältnis von A:B zwischen 2:1 und 1:3 und vorzugsweise zwischen 1:1 und 2:3 liegt.

3. Lötmaskenzusammensetzung nach Anspruch 1, dadurch gekennzeichnet, dass das Verhältnis von C:A zwischen 1:6 und 6:1 und vorzugsweise zwischen 2:1 und 6:1 liegt.

4. Lötmaskenzusammensetzung nach Anspruch 1, dadurch gekennzeichnet, dass das das Kleben verhindernde Mittel ein Polydimethylsiloxan mit einer Viskosität von 0,025 bis 0,5 Pa.s und vorzugsweise von 0,1 bis 0,3 Pa.s bei 25°C ist.

5. Lötmaskenzusammensetzung nach einem oder mehreren der Ansprüche 1 bis 4, dadurch gekennzeichnet, dass sie eine Viskosität von 0,7 bis 15 Pa.s bei 25°C aufweist.

6. Lötmaskenzusammensetzung nach Anspruch 5, dadurch gekennzeichnet, dass sie eine Viskosität von 1,0 bis 13,0, vorzugsweise von 7,0 bis 12,5 Pa.s bei 25°C aufweist.

7. Lötmaskenzusammensetzung nach den Ansprüchen 1 und 3, dadurch gekennzeichnet, dass der Füllstoff eine Teilchengrösse von 0,1 bis 20 μm, vorzugsweise von 0,1 bis 5 μm aufweist.

8. Verfahren zum Herstellen einer wieder entfernbaren Lötmaske, dadurch gekennzeichnet, dass eine Lötmaskenzusammensetzung gemäss den Ansprüchen 1 bis 7 im Siebdruck auf eine Unterlage in einem bestimmten Muster aufgetragen und durch Trocknen gehärtet wird und dass die Lötmaske nach dem Auftragen eines Lots, das in den von der Maske nicht bedeckten Bereichen auf der Unterlage haftet, wieder entfernt wird.

9. Verfahren nach Anspruch 8, dadurch gekennzeichnet, dass die Lötmaskenzusammensetzung in einer Schichtdicke von etwa 0,025 bis 0,635 mm, vorzugsweise von 0,127 bis 0,25 mm aufgetragen wird.

10. Verfahren nach Anspruch 9, dadurch gekennzeichnet, dass die Lötmaske durch Trocknen bei einer Temperatur von 50 bis 150°C gehärtet wird.

11. Verfahren nach Anspruch 8, dadurch gekennzeichnet, dass das Lot bei Temperaturen zwischen 300 und 400°C aufgetragen wird.

12. Verfahren nach Anspruch 8, dadurch gekennzeichnet, dass die Lötmaske durch Abschrecken der gelöteten Unterlage auf eine Temperatur zwischen 100 und 180°C unter Einwirken eines Lösungsmittels wieder entfernt wird.

## Claims

1. Screenable, strippable solder mask composition containing: A) a film-forming polymer in liquid form, B) a detackifier, and C) a solid, high temperature resistant filler, characterized in that the film-forming polymer A) is a polyimide/amide of pyromellitic dianhydride and 4,4'-diaminodiphenylether, dissolved in N-methyl-2-pyrrolidone, with a viscosity of the solution of 0.025 to 0.15 Pa.s at 25°C, the detackifier B) is selected from the group consisting of liquid silicone oil, terpene, terpineol, drying oil, or mixtures thereof, and the solid, high temperature resistant filler C) is selected from the group consisting of ground glass, zinc oxide, silicon dioxide, aluminum oxide, sand, and mixtures thereof.

2. Solder mask composition as claimed in claim 1, characterized in that the ratio of A:B is between 2:1 and 1:3 and preferably between 1:1 and 2:3.

3. Solder mask composition as claimed in claim 1, characterized in that the ratio of C:A is between 1:6 and 6:1 and preferably between 2:1 and 6:1.

4. Solder mask composition as claimed in claim 1, characterized in that the detackifier is a polydimethyl-siloxane with a viscosity of 0.025 to 0.5 Pa.s and preferably of 0.1 to 0.3 Pa.s at 25°C.

5. Solder mask composition as claimed in any one or several of claims 1 to 4, characterized in that it has a viscosity of 0.7 to 15 Pa.s at 25°C.

6. Solder mask composition as claimed in claim 5, characterized in that it has a viscosity of 1.0 to 13.0, preferably of 7.0 to 12.5 Pa.s at 25°C.

7. Solder mask composition as claimed in claims 1 to 3, characterized in that the filler has a particle size of 0.1 to 20 μm, preferably of 0.1 to 5 μm.

8. Method of making a strippable solder mask, characterized in that a solder mask composition as claimed in claims 1 to 7 is screen printed onto a substrate in a predetermined pattern, and cured by drying, and that the solder mask is removed again after the application of solder which in the areas not covered by the mask adheres to the substrate.

9. Method as claimed in claim 8, characterized in that the solder composition is applied in a layer thickness of approximately 0.025 to 0.635 mm, preferably of 0.127 to 0.25 mm.

10. Method as claimed in claim 9, characterized in that the solder mask is cured by means of drying at a temperature of 50 to 150°C.

11. Method as claimed in claim 8, characterized in that the solder is applied at temperatures between 300 and 400°C.

12. Method as claimed in claim 8, characterized in that the solder mask is stripped off by quenching the soldered substrate to a temperature between 100 and 180°C and by exposure to a solvent.

## Revendications

1. Composition de masque de soudage pouvant être mise en œuvre pour la sérigraphie et être ensuite éliminée, et possédant une teneur en A) d'un polymère sous forme liquide formant une pellicule, B) d'une substance empêchant le collage, et C) d'une substance de remplissage solide résistant aux températures élevées, caractérisée en ce que – le polymère A formant une pellicule est un polyimide/amide constitué par du dianhydride de l'acide pyromellitique et du 4,4'-diamino-diphényléther, dissous dans de la N-méthyl-2-pyrrolidone, avec une viscosité de la solution comprise entre 0,025 et 0,15 Pa.s à 25°C, – la substance B empêchant le collage est choisie parmi le groupe incluant l'huile silicone liquide, le terpène, le terpinéol, l'huile siccative ou des mélanges de ces produits, et – la substance de remplissage solide C) résistant aux températures très élevées est choisie dans le groupe incluant le verre broyé, l'oxyde de zinc, le bioxyde de silicium, l'oxyde d'aluminium, le sable et des mélanges de ces substances.

2. Composition de masque de soudage selon la revendication 1, caractérisée en ce que le rapport A:B est compris entre 2:1 et 1:3 et de préférence entre 1:1 et 2:3.

3. Composition de masque de soudage selon la revendication 1, caractérisée en ce que le rapport C:A est compris entre 1:6 et 6:1 et de préférence entre 2:1 et 6:1.

4. Composition de masque de soudage selon la revendication 1, caractérisée en ce que la substance empêchant le collage est un polydiméthylsiloxane possédant une viscosité comprise entre 0,025 et 0,5 Pa.s et de préférence entre 0,1 et 0,3 Pa.s à 25°C.

5. Composition de masque de soudage selon une ou plusieurs des revendications 1 à 4, caractérisée en ce qu'elle possède une viscosité comprise entre 0,7 et 15 Pa.s à 25°C.

6. Composition de masque de soudage selon la revendication 5, caractérisée en ce qu'il possède une viscosité comprise entre 1 et 13 et de préférence entre 7 et 12,5 Pa.s.

7. Composition de masque de soudage selon les revendications 1 et 3, caractérisée en ce que la substance de remplissage possède des particules d'une taille comprise entre 0,1 et 20 μm et de préférence entre 0,1 et 5 μm.

8. Procédé pour fabriquer un masque de soudage pouvant être à nouveau éliminé, caractérisé en ce qu'on appose sur un support, selon un modèle déterminé, une composition de masque de soudage conforme aux revendications 1 à 7, pour la sérigraphie, et qu'on la fait durcir par séchage, qu'on enlève à nouveau le masque de soudage après le dépôt d'une soudure qui adhère au support dans les zones non recouvertes par le masque.

9. Procédé selon la revendication 8, caractérisé en ce qu'on dépose la composition de masque de soudage avec une épaisseur de couche comprise entre environ 0,025 et 0,635 mm de préférence entre 0,127 et 0,25 mm.

10. Procédé selon la revendication 9, caractérisé en ce qu'on fait durcir le masque de soudage par séchage à une température comprise entre 50 et 150°C.

11. Procédé selon la revendication 8, caractérisé en ce qu'on dépose la soudure à des températures comprises entre 300 et 400°C.

12. Procédé selon la revendication 8, caractérisé en ce que l'on élimine à nouveau le masque de soudage par trempe du support soudé à une température comprise entre 100 et 180°C, moyennant l'action d'un solvant.